Europäisches Patentamt

European Patent Office

Office européen des brevets

(19)

(11) **EP 1 235 356 B1**

(12) **FASCICULE DE BREVET EUROPEEN**

(45) Date de publication et mention
de la délivrance du brevet:
**12.10.2005 Bulletin 2005/41**

(51) Int Cl.⁷: **H04B 1/30**, H04L 25/06

(21) Numéro de dépôt: **02290222.5**

(22) Date de dépôt: **31.01.2002**

(54) **Dispositif de réception pour un terminal de radiocommunication mobile**

Empfänger für ein mobiles Funkkommunikationsendgerät

Receiver for a mobile radio communication terminal

(84) Etats contractants désignés:
**AT BE CH CY DE DK ES FI FR GB GR IE IT LI LU
MC NL PT SE TR**

(30) Priorité: **22.02.2001 FR 0102391**

(43) Date de publication de la demande:
**28.08.2002 Bulletin 2002/35**

(73) Titulaire: **TCL & ALCATEL MOBILE PHONES
LIMITED
Hong Kong (CN)**

(72) Inventeurs:
• **Da Rocha, Alexandre
Santa Clara, CA 95050 (US)**
• **Perrin, Jean-Hugues
95100 Argenteuil (FR)**
• **Anandanarayanane, Paul
94800 Villejuif (FR)**

(74) Mandataire: **Feray, Valérie et al
Feray Lenne Conseil
39/41, avenue Aristide Briand
92163 Antony (FR)**

(56) Documents cités:
**EP-A- 0 719 013        EP-A- 0 840 484
EP-A- 0 895 385         WO-A-00/16490**

## Description

La présente invention concerne un dispositif de réception pour terminal de radiocommunication mobile. L'invention se rapporte donc plus particulièrement au domaine des systèmes de télécommunication.

Dans la partie haute fréquence d'un terminal de radiocommunication mobile, les composants analogiques mis en oeuvre apportent des imperfections au signal de réception fourni par l'antenne.

C'est le cas notamment de l'oscillateur local. L'oscillateur local produit un signal à haute-fréquence qui est appliqué au changeur de fréquence en même temps que le signal de réception, de façon à enlever la porteuse sur laquelle le signal de réception est transmis dans le canal de propagation.

Le changeur de fréquence permet en fait de transposer la fréquence du signal de réception à une fréquence plus faible.

Or, des défauts sont inhérents au fonctionnement de l'oscillateur local et du changeur de fréquence.

En particulier, l'oscillateur local rajoute une composante continue, qui est donc à la fréquence 0 Hz (hertz), au signal de réception. Cette composante continue a pour effet de décaler le signal de réception vers le haut ou vers le bas et son amplitude dépend de la puce et de l'isolation de la carte.

L'oscillateur local est également affecté de fuites qui sont rayonnées dans l'atmosphère après avoir été réacheminées au niveau de l'antenne du terminal de radiocommunication mobile. Ces fuites vont alors revenir au niveau du dispositif de réception du terminal de radiocommunication mobile à la suite de réflexions sur des obstacles externes, créant ainsi un signal parasite supplémentaire au signal de réception. Ce signal parasite constitue la composante dynamique des perturbations apportées au signal de réception par le comportement de l'oscillateur local et du changeur de fréquence.

En effet, la position en fréquence de la raie qui apparaît due au phénomène de va-et-vient expliqué ci-dessus ne peut pas être maîtrisée à cause notamment du moment où se produit la réflexion et de la vitesse de déplacement du terminal de radiocommunication mobile. La fréquence de la composante dynamique est donc liée à l'effet Doppler et dépend de la vitesse du terminal de radiocommunication mobile.

L'amplitude de cette composante dynamique ne peut également pas être maîtrisée.

Le fonctionnement de l'oscillateur local et du changeur de fréquence dans le récepteur du terminal de radiocommunication mobile entraîne donc des perturbations au niveau du signal de réception. Ces perturbations se traduisent d'une part, par l'apparition d'une composante continue ou statique à la fréquence 0 Hz et, d'autre part, par l'apparition d'une composante dynamique de fréquence et d'amplitude quelconque.

Ces composantes statique et dynamique doivent être impérativement supprimées pour assurer le bon fonctionnement du récepteur du terminal de radiocommunication mobile.

Une solution de l'art antérieur prévoit d'équiper le récepteur du terminal avec un filtre de façon à éliminer la composante statique et la composante dynamique des perturbations au signal de réception induites par l'oscillateur local et le changeur de fréquence.

Le filtre utilisé est un filtre de type passe-haut. Il est disposé entre le changeur de fréquence et le convertisseur analogique numérique dans le récepteur du terminal de radiocommunication mobile. Cette solution est donc mise en oeuvre dans le domaine analogique.

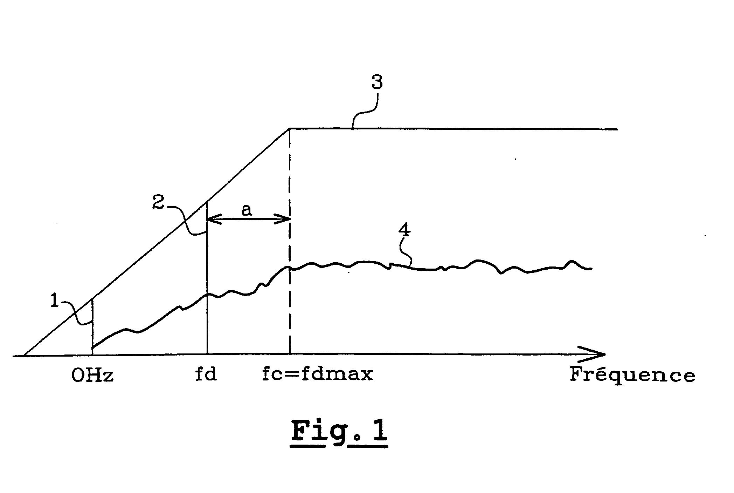

Néanmoins, l'utilisation d'un tel filtre dans le récepteur présente des inconvénients importants. Ces inconvénients se trouvent illustrés à la figure 1.

La figure 1 montre la composante statique 1 à zéro Hertz, la composante dynamique 2, de fréquence égale à fd, la réponse spectrale 3 du filtre passe-haut utilisé, ainsi que le signal utile 4, c'est-à-dire le signal reçu portant l'information désirée.

Le filtre se caractérise par une pente et par une fréquence de coupure fc. La fréquence de coupure fc est choisie suffisamment élevée de façon à pouvoir supporter le maximum de décalage de la composante dynamique 2, soit fc = fdmax. En effet, le positionnement en fréquence de la composante dynamique 2, qui dépend en partie de la vitesse de déplacement du terminal de radiocommunication mobile, comme expliqué plus haut, ne peut être maîtrisé et bouge en fonction de la fréquence Doppler. Ainsi, le filtre passe-haut utilisé est caractérisé de telle manière que le récepteur puisse supporter une certaine plage de vitesse et donc des variations de la composante dynamique importantes allant jusqu'à cette plage de vitesse.

Or, le filtre est figé et ne peut être adapté à toutes les situations.

Ainsi, sur l'exemple de la figure 1, bien qu'effectivement le filtre utilisé permet de supprimer les deux composantes, statique et dynamique, il atténue fortement également toute la partie du signal modulé utile référencée a sur la figure 1.

L'atténuation non désirée de la partie a du signal utile entraîne des dégradations importantes. Par conséquent, les performances en terme de démodulation sont altérées, ce qui se traduit par une dégradation du taux d'erreurs binaire BER, et la baisse de ces performances est directement liée aux caractéristiques du filtre passe-haut utilisé, notamment la fréquence de coupure du filtre.

Une deuxième solution de l'art antérieur consiste à éliminer les composantes statique et dynamique des perturbations au signal de réception en traitant le signal après sa conversion analogique numérique par l'intermédiaire d'un algorithme de type LMS, acronyme pour l'expression anglo-saxonne « Least Mean Square ». Le traitement du signal de réception est alors entièrement effectué dans le domaine numérique.

Cependant, ce type d'algorithme, d'une part, est très complexe à mettre en oeuvre et, d'autre part, il nécessite une puissance de calcul très élevée qui en devient rédhibitoire et ne permet pas egalement d'optimiser le convertisseur analogique-numerique.

Aussi, le but que se propose d'atteindre la présente invention est de permettre la suppression à la fois de la composante statique et de la composante dynamique des perturbations au signal de réception induites par le fonctionnement de l'oscillateur local et du changeur de fréquence, tout en palliant les inconvénients de l'art antérieur, soit sans altérer les performances en terme de démodulation du terminal de radiocommunication mobile et sans complexité déraisonnable.

Pour ce faire, l'invention propose de combiner les deux solutions précédemment exposées.

Selon l'invention, le traitement du signal, pour l'élimination des composantes statique et dynamique des perturbations, s'effectue en deux parties.

Une première partie est effectuée en analogique et une deuxième partie est effectuée en numérique.

Ainsi, la suppression des composantes statique et dynamique est partagée entre le domaine analogique et le domaine numérique.

L'invention concerne donc un dispositif de réception d'un terminal de radiocommunication mobile dans un système de télécommunication, tel que défini dans la revendication 1.

Les caractéristiques du préambule de la revendication 1 sont connues du domment EP 0 719 013 A2.

L'invention concerne également un procédé tel que défini dans la revendication 7.

D'autres caractéristiques et avantages de l'invention apparaîtront plus clairement à la lecture de la description suivante d'un exemple de réalisation en référence aux figures, parmi lesquelles :

- la figure 1 est un schéma illustrant les inconvénients de l'art antérieur et a déjà été décrite ci-dessus ;
- la figure 2 est un schéma illustrant le dispositif de réception selon la présente invention ;
- la figure 3 est un schéma plus précis reprenant une partie du schéma de la figure 2.

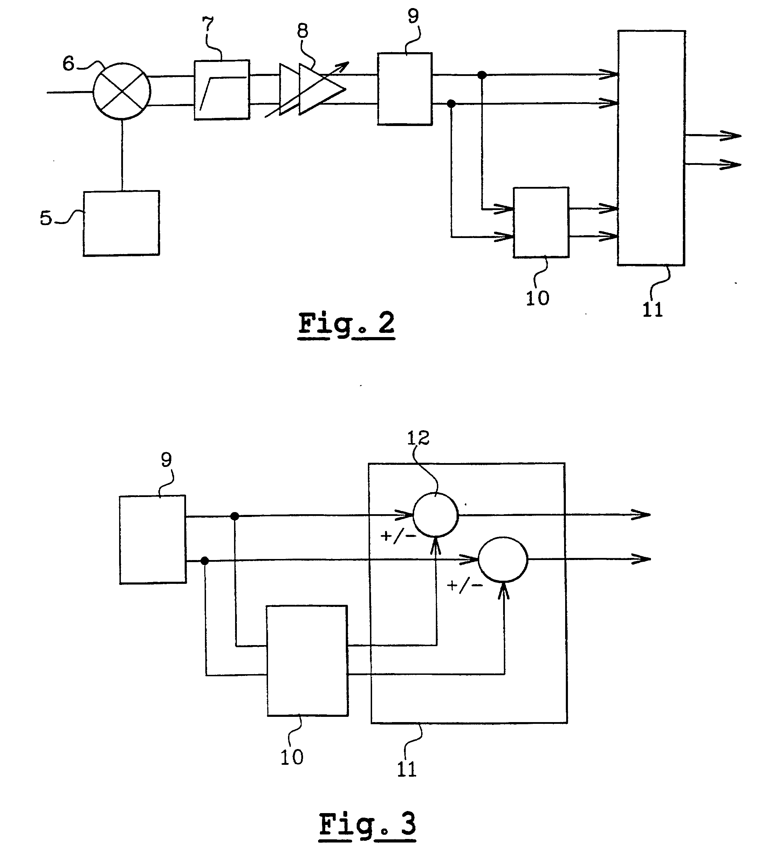

En référence à la figure 2, des moyens de génération de signaux à haute-fréquence 5 produisent un signal à haute-fréquence qui est appliqué à une première borne d'entrée de moyens de transposition de la fréquence 6 en même temps que le signal de réception est appliqué sur une seconde borne d'entrée de façon à transposer la fréquence du signal de réception à une fréquence plus faible.

Les moyens de génération de signaux à haute-fréquence 5 sont typiquement un oscillateur local et les moyens de transposition de la fréquence 6 sont typiquement un changeur de fréquence.

Des moyens de filtrage 7 de type passe-haut sont disposés en sortie du changeur de fréquence 6 en amont de moyens de numérisation 9 du signal de réception. Les moyens de numérisation 9 peuvent se présenter sous la forme d'un convertisseur analogique numérique.

De façon avantageuse, un amplificateur intermédiaire 8 peut-être prévu entre les moyens de filtrage 7 et le convertisseur 9 de façon à adapter l'amplitude du signal au convertisseur 9.

Les sorties du convertisseur analogique numérique 9 sont reliées d'une part, à un dispositif correcteur 11 et, d'autre part, à un filtre numérique 10. Le filtre numérique 10 est de type passe-haut et peut être un filtre à réponse impulsionnelle finie.

Les sorties du filtre numérique 10 sont également reliées au dispositif correcteur 11.

Les premiers moyens de filtrage 7 mettent donc en oeuvre un filtrage de type passe-haut qui permet d'éliminer toute la composante statique ainsi qu'une partie de la composante dynamique des perturbations au signal de réception induites par le fonctionnement des moyens de génération de signaux à haute-fréquence 5 et par le fonctionnement des moyens de transposition de la fréquence 6.

Ainsi, la fréquence de coupure fc des moyens de filtrage 7 est prédéterminée de la façon suivante :

$$fc = fdmax . (1-x)$$

fdmax étant la valeur de la fréquence Doppler maximale que le récepteur est susceptible de supporter. En d'autres termes, fdmax correspond au positionnement en fréquence le plus élevé de la composante dynamique des perturbations au signal de réception que le récepteur peut supporter.

Dans la relation ci-dessus permettant de fixer la fréquence de coupure fc des premiers moyens de filtrage 7, x est exprimé en pourcentage.

x, et donc la fréquence de coupure fc, est prédéterminé de façon à réduire le nombre de bits pour le traitement des moyens de numérisation 9. La fréquence de coupure ainsi déterminée permet alors d'éliminer une première partie des composantes des perturbations au signal de réception. Cette première partie éliminée comprend la composante statique ainsi qu'une partie de la composante dynamique. On fait donc en sorte de raboter au maximum cette composante dynamique de telle façon qu'elle soit déjà réduite quand le signal entre dans le convertisseur.

Quant à la partie restante de la composante dynamique des perturbations au signal de réception, elle va être entièrement éliminée par l'intermédiaire d'une part, du filtre numérique 10 qui est placé après les moyens de numérisation 9 et, d'autre part, du dispositif correcteur 11.

Dans l'explication qui va suivre, on considère un système de télécommunication de type WCDMA, acronyme pour l'expression anglo-saxonne « Wideband Code Division Multiple Access ».

Dans un système de télécommunication de type WCDMA, les signaux transmis respectent un format particulier. Ainsi les signaux sont transmis sous forme de trames, et chaque trame est divisée en quinze tranches de temps appelées « slot ». Chaque slot contient 2 560 valeurs dans un système WCDMA.

Le dispositif de réception selon la présente invention est cependant adapté à tout type de système de télécommunication. L'explication suivante dans le cadre d'un système de type WCDMA est simplement donnée à titre d'exemple et ne doit pas être interprétée comme une limitation à la portée de l'invention.

Le signal issu du convertisseur analogique numérique 9, noté $S_n$, contient le signal voulue $Sv^{voulu}_n$, le signal venant des autres utilisateurs à l'intérieur de la cellule courante $S^{intra-interf}_n$, les interférences correspondant aux signaux venant des autres cellules voisines $s^{inter-interf}_n$, du bruit blanc gaussien additif $n_n$ et enfin la composante dynamique $DC_k$ résiduelle des perturbations au signal de réeception induites par les moyens de génération de signaux à haute fréquence 5 et par les moyens de transposition de la fréquence 6. Ainsi, $S_n = S^{voulu}_n + S^{intra-interf}_n + S^{inter-interf}_n + n_n + DC_k$.

Il reste donc à estimer la composante dynamique résiduelle $DC_k$ qui n'a pas été éliminée par les premiers moyens de filtrage 7 de type passe-haut mis en oeuvre avant le convertisseur 9.

Pour ce faire, le signal $S_n$ va être traité dans le filtre numérique 10 qui est placé après le convertisseur 9. La fonction du filtre numérique 10 consiste donc à calculer la composante dynamique résiduelle $DC_k$, puis à fournir au dispositif correcteur 11 le signal représentatif de cette composante résiduelle des perturbations au signal de réception.

Le dispositif correcteur 11 va alors se charger d'extraire cette composante résiduelle du signal $S_n$ issu du convertisseur analogique numérique 9.

Le traitement mis en oeuvre dans le filtre numérique 10 consiste à moyenner le signal $S_n$ sur un nombre de trames déterminé et donc sur un nombre de slots déterminé.

Bien que l'explication qui suit est fournie en référence à un système de type WCDMA, ce traitement peut être mis en oeuvre dans tout type de système de télécommunication.

Dans une première étape, on calcule la valeur moyenne $m_k$ du signal reçu sur un slot complet ou sur une portion de slot. Le calcul est effectué de la façon suivante pour le slot ou la tranche de temps d'indice k:

$$m_k = \sum_{n=1}^{2560(1-p)} S_n = \sum_{n=1}^{2560(1-p)} S^{voulu}_n + \sum_{n=1}^{2560(1-p)} S^{intra-interf}_n + \sum_{n=1}^{2560(1-p)} S^{inter-interf}_n + \sum_{n=1}^{2560(1-p)} n_n + \sum_{n=1}^{2560(1-p)} DC_k$$

La variable p permet de déterminer la portion de slot ou de tranche de temps sur laquelle est effectué le calcul. Par exemple, si p est pris égal à 0.2, le calcul de $m_k$ est effectué sur 80% des valeurs du slot.

Dans un système de type WCDMA, tous les signaux sont centrés sur zéro. Les valeurs moyennes des signaux $S^{voulu}_n$, $S^{intra-interf}_n$, $S^{inter-interf}_n$ et $n_n$ sont donc nulles, on obtient alors :

$$m_k = 2\,560. (1-p).DC_k$$

En effet, la composante dynamique résiduelle $DC_k$ ne varie quasiment pas sur l'intervalle de tranche de temps d'indice k considéré.

Une deuxième étape consiste à déterminer l'espacement P, exprimé en nombre de slots ou tranches de temps, à prendre en compte entre deux calculs consécutifs $m_k$ de la valeur moyenne du signal sur un slot ou une portion de slot.

En effet, il n'est pas nécessaire de moyenner le signal sur des slots consécutifs. Le calcul détaillé à l'étape précédente pour obtenir la valeur moyenne $m_k$ du signal, soit sur un slot complet, soit sur une portion de slot, peut ainsi être effectué tous les slots, tous les deux slots, tous les trois slots, etc...

La variable P détermine cet espacement et selon la configuration souhaitée P prendra différentes valeurs. A savoir, s'il est souhaité de faire uniquement une estimation $m_k$ par trame, P sera alors égal à 14, s'il est souhaité de faire deux estimations $m_k$ par trame, P sera égal à 28 et ainsi de suite. De plus, pour avoir plusieurs estimations $m_k$ par trame, il suffit de prendre P < 14. Dans les explications qui suivent, il a été choisi P < 14.

Une troisième étape consiste à déterminer le nombre N de termes $m_k$ représentant la valeur moyenne du signal, sur un slot complet ou sur une portion de slot, à considérer pour réaliser l'estimation de la composante dynamique résiduelle des perturbations au signal de réception.

Grâce au paramètre N, l'algorithme permet d'estimer la composante dynamique résiduelle sur la base d'une trame complète ou encore sur la base d'une portion de trame. Ainsi, seules N valeurs moyennes $m_k$ consécutives espacées de P slots sont prises en compte pour l'estimation de la composante dynamique résiduelle.

Enfin, une dernière étape consiste à calculer la composante dynamique résiduelle estimée sur la trame courante T.

Cette étape consiste à effectuer le calcul suivant :

$$DC_T^{estimé} = \frac{1}{N.2560.(1-p)} \cdot \sum_{k=0}^{N-1} m_k$$

L'estimation de la composante dynamique résiduelle $DC^{estimé}_T$ correspond à l'estimation instantanée pour la trame courante référencée T.

De façon à minimiser l'impact d'une erreur d'estimation instantanée, on tient compte de l'historique des estimations de la composante dynamique résiduelle. Pour ce faire, un facteur d'oubli $\alpha$ est mis en oeuvre et la valeur de la composante dynamique résiduelle est moyennée comme suit sur la trame courante T :

$$DC_T^{moyenné} = (1-\alpha). DC_T^{estimé} + \alpha.DC_{T-1}^{moyenné}, 0 \leq \alpha < 1$$

Suivant la valeur de $\alpha$, on pondère donc plus ou moins le résultat en fonction de la valeur de la composante dynamique résiduelle $DC^{moyenné}_{T-1}$ calculée sur la trame précédente référencée T-1.

Pour finir, le filtre numérique 10 fournit au dispositif correcteur 11 le signal représentatif de la composante dynamique résiduelle des perturbations au signal de réception $DC^{moyenné}_T$.

Le dispositif correcteur 11 extrait alors cette composante du signal issu des moyens de numérisation 9 par l'intermédiaire de moyens de soustraction 12, voir à la figure 3.

Le signal de sortie du dispositif correcteur 11 est donc égal à la différence entre le signal issu du convertisseur 9 et le signal calculé par le filtre numérique 10 représentant la composante dynamique résiduelle des perturbations au signal de réception.

L'algorithme mis en oeuvre est donc beaucoup moins complexe qu'un algorithme de type LMS et permet également une grand flexibilité pour le calcul de la composante dynamique résiduelle.

De plus, l'invention permet d'optimiser la plage d'utilisation du convertisseur analogique numérique puisqu'une partie des composantes des perturbations au signal de réception est supprimée avant le passage en numérique par l'intermédiaire des premiers moyens de filtrage. La consommation de puissance s'en trouve donc réduite.

## Revendications

**1.** Dispositif de réception d'un terminal de radiocommunication mobile dans un système de télécommunication dans lequel le signal est transmis sous forme de trames divisées en tranche de temps, comprenant des moyens de génération de signaux à haute-fréquence (5) coopérant avec des moyens de transposition de la fréquence (6) pour transposer la fréquence du signal de réception à une fréquence plus faible, des moyens de filtrage de type passe-haut (7) pour filtrer la composante statique et la composante dynamique des perturbations au signal de réception induites par le fonctionnement desdits moyens de génération de signaux à haute-fréquence (5) et de transposition de la fréquence (6), et des moyens de numérisation (9), la fréquence de coupure (fc) des moyens de filtrage de type passe-haut (7) étant prédéterminée de façon à éliminer ladite composante statique et une partie de ladite composante dynamique avant que le signal n'entre dans les moyens de numérisation (9), ledit dispositif étant **caractérisé en ce qu'**il comporte un filtre numérique (10) placé après les moyens de numérisation (9) et adapté à moyenner le signal ($S_n$) issu des moyens de numérisation (9) sur un nombre de trames déterminé de manière à calculer la composante dynamique résiduelle et **en ce qu'**il comporte un dispositif correcteur (11) adapté à extraire la composante dynamique résiduelle calculée par le filtre numérique (10) du signal issu des moyens de numérisation (9).

**2.** Dispositif selon la revendication 1,
**caractérisé en ce que** le filtre numérique (10) est du type passe-haut.

**3.** Dispositif selon l'une des revendications précédentes, **caractérisé en ce que** le dispositif correcteur (11) comprend des moyens de soustraction (12) pour extraire la composante dynamique résiduelle du signal issu des moyens de numérisation (9).

**4.** Dispositif selon la revendication 4,
**caractérisé en ce que** les moyens de soustraction (12) opèrent la différence entre le signal issu des moyens de numérisation (9) et le signal représentatif de la composante dynamique résiduelle issu du filtre numérique (10).

**5.** Procédé de réception d'un signal radiofréquence dans un système de télécommunication, dans lequel le signal est transmis sous forme de trames divisées en tranche de temps, comprenant les étapes consistant à :

- filtrer la composante statique et une partie de la composante dynamique du signal radiofréquence reçu ;
- numériser un signal radiofréquence reçu par un terminal de radiocommunication ;

**caracterisé en ce qu'**il comprend en outre les étapes consistant à :

- calculer la valeur moyenne du signal sur une tranche de temps et sur un nombre de termes déterminé;
- déterminer l'espacement entre deux calculs consécutifs de la valeur moyenne du signal sur une tranche de temps, l'espacement étant exprimé en nombre de tranches de temps ;
- déterminer le nombre de termes représentant la valeur moyenne du signal sur une tranche de temps à considérer ;
- calculer une composante dynamique résiduelle des perturbations au signal de réception basé sur l'espacement et le nombre de termes déterminé;
- extraire la composante dynamique résiduelle du signal numérisé.

**6.** Procédé selon la revendication 5 **caractérisé en ce que** le calcul de la valeur moyenne du signal est effectué sur une portion de tranche de temps.

**7.** Procédé selon la revendication 6 **caractérisé en ce que** l'étape de calcul de la composant dynamique du signal consiste à calculer d'abord l'estimation instantanée de la composante dynamique résiduelle, puis à moyenner cette estimation en mettant en oeuvre un facteur d'oubli de façon à tenir compte de l'historique des estimations de la composante dynamique résiduelle.

**8.** Procédé selon l'une des revendications 5 à 7, **caractérisé en ce que** les différentes étapes sont mises en oeuvre dans un filtre numérique (10) placé après des moyens de numérisation (9).

**Patentansprüche**

**1.** Empfangsvorrichtung eines mobilen Funkkommunikationsendgeräts in einem Telekommunikationssystem, in dem das Signal in Form von in Zeitschlitze unterteilten Rahmen übertragen wird, mit Hochfrequenzsignal-Erzeugungsmitteln (5), die mit Frequenzumsetzungsmitteln (6) zusammenwirken, um die Frequenz des Empfangssignals in eine niedrigere Frequenz umzusetzen, Hochpassfiltermitteln (7), um die statische Komponente und die dynamische Komponente von Störungen des Empfangssignals, die durch den Betrieb der Hochfrequenzsignal-Erzeugungsmittel (5) und der Frequenzumsetzungsmittel (6) eingeführt werden, zu filtern, und Digitalisierungsmitteln (9), wobei die Kappungsfrequenz (fc) der Hochpassfiltermittel (7) in der Weise vorgegeben ist, dass die statische Komponente und ein Teil der dynamischen Komponente beseitigt werden, bevor das Signal in die Digitalisierungsmittel (9) eintritt, wobei die Vorrichtung **dadurch gekennzeichnet ist, dass** sie ein digitales Filter (10) umfasst, das hinter den Digitalisierungsmitteln (9) angeordnet und so beschaffen ist, dass es das von den Digitalisierungsmitteln (9) ausgegebene Signal (Sn) über eine bestimmte Anzahl von Rahmen mittelt, derart, dass die verbleibende dynamische Komponente berechnet wird, und dass sie eine Korrekturvorrichtung (11) umfasst, die so beschaffen ist, dass sie die durch das digitale Filter (10) berechnete verbleibende dynamische Komponente des von den Digitalisierungsmitteln (9) ausgegebenen Signals extrahiert.

2.  Vorrichtung nach Anspruch 1, **dadurch gekennzeichnet, dass** das digitale Filter (10) vom Hochpasstyp ist.

3.  Vorrichtung nach einem der vorhergehenden Ansprüche, **dadurch gekennzeichnet, dass** die Korrekturvorrichtung (11) Subtraktionsmittel (12) umfasst, um die verbleibende dynamische Komponente des von den Digitalisierungsmitteln (9) ausgegebenen Signals zu extrahieren.

4.  Vorrichtung nach Anspruch 4, **dadurch gekennzeichnet, dass** die Subtraktionsmittel (11) an der Differenz zwischen dem von den Digitalisierungsmitteln (9) ausgegebenen Signal und dem Signal, das die von dem digitalen Filter (10) ausgegebene verbleibende dynamische Komponente repräsentiert, arbeiten.

5.  Verfahren zum Empfangen eines Hochfrequenzsignals in einem Telekommunikationssystem, in dem das Signal in Form von in Zeitschlitze unterteilten Rahmen übertragen wird, das die Schritte umfasst, die darin bestehen:

    -   die statische Komponente und einen Teil der dynamischen Komponente des empfangenden Hochfrequenzsignals zu filtern;
    -   ein von einem Funkkommunikationsendgerät empfangenes Hochfrequenzsignal zu digitalisieren;

    **dadurch gekennzeichnet, dass** es außerdem die Schritte umfasst, die darin bestehen:

    -   den Mittelwert des Signals über einen Zeitschlitz und über eine bestimmte Anzahl von Rahmen zu berechnen;
    -   den Abstand zwischen zwei aufeinander folgenden Berechnungen des Mittelwerts des Signals über einen Zeitschlitz zu bestimmen, wobei der Abstand durch die Anzahl von Zeitschlitzen ausgedrückt wird;
    -   die Anzahl von Termen zu bestimmen, die den Mittelwert des Signals über einen betrachteten Zeitschlitz repräsentieren;
    -   eine verbleibende dynamische Komponente der Störungen des Empfangssignals auf der Grundlage des bestimmten Abstandes und der bestimmten Anzahl von Termen zu berechnen;
    -   die verbleibende dynamische Komponente des digitalisierten Signals zu extrahieren.

6.  Verfahren nach Anspruch 5, **dadurch gekennzeichnet, dass** die Berechnung des Mittelwerts des Signals an einem Zeitschlitz-Abschnitt ausgeführt wird.

7.  Verfahren nach Anspruch 6, **dadurch gekennzeichnet, dass** der Schritt des Berechnens der dynamischen Komponente des Signals darin besteht, zunächst die momentane Schätzung der verbleibenden dynamischen Komponente zu berechnen und dann diese Schätzung zu mitteln, indem ein Vergessensfaktor eingeführt wird, der die Historie der Schätzungen der verbleibenden dynamischen Komponente berücksichtigt.

8.  Verfahren nach einem der Ansprüche 5 bis 7, **dadurch gekennzeichnet, dass** die verschiedenen Schritte in einem digitalen Filter (10) ausgeführt werden, das hinter den Digitalisierungsmitteln (9) angeordnet ist.

## Claims

1.  Receiver device of a mobile radio communications terminal in a telecommunications system in which the signal is transmitted in the form of frames divided into time slots, comprising means for generating high frequency signals (5) cooperating with frequency conversion means (6) to down convert the frequency of the reception signal, filtering means of high-pass type (7) to filter the static component and the dynamic component of reception signal interference induced by the functioning of said means for generating high frequency signals (5) and said frequency conversion means (6), and digitization means (9), the cut-off frequency (fc) of the filtering means of high-pass type (7) being predetermined so as to eliminate said static component and part of said dynamic component before the signal enters the digitization means (9), said device being **characterized in that** it comprises a digital filter (10) positioned after the digitization means (9) and adapted to average the signal ($S_n$) derived from the digitization means (9) over a determined number of frames so as to calculate the residual dynamic component, and **in that** it comprises a corrector device (11) adapted to extract the residual dynamic component calculated by digital filter (10) from the signal derived from the digitization means (9).

2.  Device as in claim 1, **characterized in that** the digital filter (10) is of high-pass type.

3. Device as in any of the preceding claims, **characterized in that** the corrector device (11) comprises subtraction means (12) to extract the residual dynamic component from the signal derived from the digitization means (9).

4. Device as in claim 4, **characterized in that** the subtraction means (12) operate the difference between the signal derived from the digitization means (9) and the signal representing the residual dynamic component derived from the digital filter (10).

5. Method for receiving a radiofrequency signal in a telecommunications system in which the signal is transmitted in the form of frames divided into time slots, comprising the steps consisting of:

   - filtering the static component and part of the dynamic component of the received radiofrequency signal;
   - digitizing a radiofrequency signal received by a radio communications terminal;

   **characterized in that** it also comprises the steps consisting of:

   - calculating the mean value of the signal over a time slot and over a determined number of frames;
   - determining the spacing between two consecutive calculations of the mean signal value over a time slot, the spacing being expressed in number of time slots;
   - determining the number of terms representing the mean signal value over a time slot to be taken into consideration,
   - calculating a residual dynamic component of reception signal interference, based on the spacing and on the determined number of terms;
   - extracting the residual dynamic component from the digitized signal.

6. Method as in claim 5 **characterized in that** the calculation of the mean signal value is made over a portion of a time slot.

7. Method as in claim 6, **characterized in that** the step to calculate the dynamic component of the signal consists of calculating firstly the instantaneous estimation of the residual dynamic component, then of averaging this estimation using a forget factor so as to take into account the history of estimations of the residual dynamic component.

8. Method as in any of claims 5 to 7, **characterized in that** the different steps are performed in a digital filter (10) positioned after digitization means (9).

**Fig. 1**

**Fig. 2**

**Fig. 3**